(19) Europäisches Patentamt
European Patent Office
Office européen des brevets

(11) **EP 3 128 675 B1**

(12) **EUROPEAN PATENT SPECIFICATION**

(45) Date of publication and mention
of the grant of the patent:
**30.03.2022 Bulletin 2022/13**

(21) Application number: **16001749.7**

(22) Date of filing: **05.08.2016**

(51) International Patent Classification (IPC):
**H03M 7/40** (2006.01)

(52) Cooperative Patent Classification (CPC):
**H03M 7/40; H03M 7/405**

(54) **WIRELESS SENSOR DATA COMPRESSION**

DRAHTLOSER SENSORDATENKOMPRIMIERUNG

COMPRESSION DE DONNÉES D'UN CAPTEUR SANS FIL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.08.2015 IN 4083CH2015
21.09.2015 US 201514860678**

(43) Date of publication of application:
**08.02.2017 Bulletin 2017/06**

(73) Proprietor: **SAP SE
69190 Walldorf (DE)**

(72) Inventor: **Verma, Sudhir
69190 Walldorf (DE)**

(74) Representative: **Müller-Boré & Partner
Patentanwälte PartG mbB
Friedenheimer Brücke 21
80639 München (DE)**

(56) References cited:
**US-A1- 2014 122 022**

- **Abdoulaye Diop et al: "An Efficient and Secure
  Session Key Management Scheme for Cluster
  Based Wireless Sensors Networks" In: Qiaohung
  Zu et al: "Pervasive Computing and the
  Networked World", 1 January 2014 (2014-01-01),
  Springer International Publishing Switzerland,
  XP002763754, ISBN: 978-3-319-09264-5 pages
  33-44, * the whole document ***

- **Arup Nanda: "Compressing Columns", ORACLE
  Magazine , 2 January 2010 (2010-01-02),
  XP002763755, Retrieved from the Internet:
  URL:http://www.oracle.com/technetwork/test
  content/o10compression-082302.html [retrieved
  on 2016-11-03]**
- **D. Salomon et al.: "Data Compression 4th
  edition", 2007, Springer Verlag, XP002763756,
  ISBN: 1-84628-602-6 pages 47-169, * paragraph
  [2.19] ***
- **"A Novel Scheme for PMIPv6 Based Wireless
  Sensor Network" In: MD MOTAHARUL ISLAM ET
  AL: "FUTURE GENERATION INFORMATION
  TECHNOLOGY", 13 December 2010 (2010-12-13),
  SPRINGER BERLIN HEIDELBERG, BERLIN,
  HEIDELBERG, XP019158874, ISBN:
  978-3-642-17568-8 vol. 6485, pages 429-438, * the
  whole document ***
- **SOONHO JANG ET AL: "Cost-Effective and
  Distributed Mobility Management Scheme in
  Sensor-Based PMIPv6 Networks with SPIG
  Support" In: SOONHO JANG ET AL: "PERVASIVE
  COMPUTING AND THE NETWORKED WORLD",
  28 November 2012 (2012-11-28), SPRINGER
  BERLIN HEIDELBERG, BERLIN, HEIDELBERG,
  XP047026197, ISBN: 978-3-642-37014-4 pages
  259-273, * the whole document ***
- **K. Römer: "Time Synchronisation and Calibration
  in Wireless Sensor Networks" In: K. Römer:
  "Handbook of Sensor Networks: Algorithms and
  Architectures", 1 October 2005 (2005-10-01),
  Wiley and Sons, XP002763757, pages i-xxxix, *
  the whole document ***

**Description**

BACKGROUND

Advancements in database technologies and data compression techniques have provided efficient means for data storage. For instance, data may be compressed using known data compression techniques and stored in a database. However, there may be no provision or mechanism to identify or classify data based on data sources. In such a scenario, known data compression techniques may be inefficient and the mechanism to search for such compressed data may be cumbersome. Determining data sources, data compression techniques based on the attributes of data, and optimizing the search for data may be challenging.

The document (Diop A., Qi Y., Wang Q. (2014) "An Efficient and Secure Session Key Management Scheme for Cluster Based Wireless Sensors Networks". In: Zu Q., Vargas-Vera M., Hu B. (eds) "Pervasive Computing and the Networked World". ICPCA/SWS 2013. Lecture Notes in Computer Science, vol 8351. Springer, Cham) discloses an efficient and secure session key management scheme for cluster-based wireless sensors networks (ESSKM). The proposed technique based on symmetric key mechanism, provides an improved session key establishment by updating periodically the session key within a cluster, hence avoids different type of attacks from malicious nodes and mitigates the node compromise attack. Finally, through the network simulator tool (NS-2), the security analysis and performance simulation demonstrate that ESSKM not only achieves efficient security, but also provides energy saving with low storage overhead.

The document (Arup Nanda: "Compressing Columns", Oracle Magazine, 2 January 2010, http://www.oracle.com/technetwork/testcontent/o10compression-082302.html) discloses OLTP table compression which allows DML against compressed tables. To accommodate the demands of exponential data growth, Oracle Exadata V2 has introduced a new technology called Hybrid Columnar Compression that changes the fundamental way the data is structured inside a block. Instead of grouping rows, it groups like values in columns to make the compression ratio orders of magnitude higher. This enables databases to store more data for data warehousing and archival purposes without a corresponding size increase.

The document D. Salomon et al.: "Data Compression 4th edition" (2007, Springer Verlag, ISBN: 1-84628-602-6, pages 47-169) discloses the context tree weighting method (CTW) for text compression.

US 2014/122022 A1 discloses processing time sequence data for multiple sensors, wherein the multiple sensors are divided into multiple sensor groups and each data comprises a time stamp and a value associated with the timestamp. The method comprises: receiving time series data from each sensor; assigning the time series data received to a sensor group to which the sensor belongs; storing time series data in a first database of a first memory, such that multiple time series data assigned to the same sensor group in the multiple sensor groups are stored in at least one database record of the first database; obtaining the time series data of each sensor among the multiple sensors from the first database; storing time series data in a second database of a second memory, such that the multiple time series data from the same sensor are stored in at least one database record of the second database.

Thus, according to an aspect, the problem relates to providing a versatile method for compressing datasets.

This problem is solved by the independent claims. Preferred embodiments are defined in the dependent claims.

**BRIEF DESCRIPTION OF THE DRAWINGS**

The claims set forth the embodiments with particularity. The embodiments, together with its advantages, may be best understood from the following detailed description taken in conjunction with the accompanying drawings.

FIG. 1 is a block diagram illustrating a table including sensor dataset, according to an embodiment.
FIG. 2 is a flow diagram illustrating a process to compress a dataset, according to an embodiment.
FIG. 3 is a block diagram illustrating compression of sensor node identifier data, according to an embodiment.
FIG. 4 is a block diagram showing compression of sensor node identifier dataset, according to an embodiment.
FIG. 5 is a block diagram of a suffix tree for sensor node identifier data, according to an embodiment.
FIG. 6 is a block diagram showing compression of sensor node timestamp data, according to an embodiment.
FIG. 7 is a block diagram showing compression of sensor node timestamp data, according to an embodiment
FIG. 8 is a block diagram showing tables including compressed dataset for sensor node timestamp data, according to an embodiment.
FIG. 9 is a block diagram of a computer system, according to an embodiment.

**DETAILED DESCRIPTION**

Embodiments of techniques related to data compression are described herein. In the following description, numerous specific details are set forth to provide a thorough understanding of the embodiments.

Volume of business data associated with an enterprise may witness an exponential surge as a function of time. The business data may be structured and unstructured data, transactional data, data related to business processes, etc. A data store may correspond to an in-memory database, a web-based database, a conventional database, etc. The in-memory database may include a main memory and an underlying hardware for executing storage and computational operations. Typically, the business data may be available in the main memory and operations such as, computations and memoryreads may be executed in the main memory.

In an embodiment, a table in a database may be represented by a two dimensional data structure with cells organized in rows and columns. For instance, the business data in the in-memory database may be stored as a row store or a column store. In the row store, the fields of every row may be stored sequentially, while in the column store, the fields of every column may be stored in contiguous memory locations. Storage modeled as row store or column store may be accessed by various components of the in-memory management system. Such components may include front-end development application, database application, a query processing engine, etc.

In an embodiment, when data is stored in the column store, the values associated with business data may be intrinsically sorted and stored in several contiguous locations that may be adjacent to each other. In an embodiment, an in-memory data store may store data from multiple data sources in multiple data formats. Such data may be referred to as unified dataset and may be associated with multiple attributes. For instance, dataset associated with enterprise resource planning (ERP) data may be determined or identified by the attributes associated the ERP data; dataset associated with customer relationship management (CRM) data may be determined by the attributes associated with CRM data, and so on.

The in-memory data store may reside in a data center that is in communication with multiple sensor nodes. A sensor node may correspond to a transducer that may be configured to sense (e.g., measure or detect) specific characteristic in an environment in which the sensor node is deployed. Such measurements may also be referred to as sensor measurement data that may be transmitted to the data center. Additionally, the data transmitted to the data center may include sensor node identifier data, sensor timestamp data, etc. For instance, such dataset may be referred to as sensor data or sensor information. Hence the sensor data may be determined by the associated attributes, such as sensor node identifier, sensor node timestamp information and sensor measurement information. The sensors may be deployed in a network (e.g., Internet of Things (IoT)) of a connection of smart objects or devices such as electronic devices, software, etc., that exchange data with each other.

In an embodiment, the sensor data transmitted from the multiple sensor nodes may be received and stored in a delta storage associated with the in-memory data store. The delta storage may be configured to receive the sensor data at a particular frequency and at particular time intervals. Upon receiving the sensor data, a business logic associated with the delta storage in the in-memory data store may sort the dataset including the sensor data based on the sensor timestamp information. Upon sorting the dataset based on the sensor timestamp information, the dataset including the sensor data may be merged with a main storage associated with the in-memory data store.

In an embodiment, the in-memory data store may execute a data merge model to merge the dataset collected in the delta storage with the main storage in the in-memory data store. In an embodiment, the data in the main storage may be stored as row store or column store. The data stored in the main storage may be compressed by executing data compression models. For instance, a dataset stored in the in-memory data store may be determined by attributes associated with the dataset and a data compression model may be determined and executed to compress the corresponding dataset.

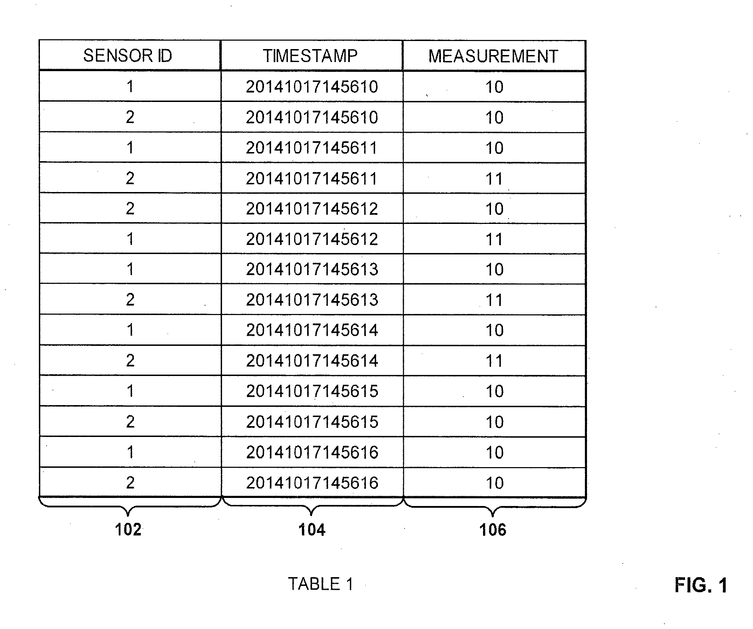

FIG. 1 is a block diagram illustrating a table including sensor dataset, according to an embodiment. By way of illustration, FIG. 1 shows table 1 including dataset stored in an in-memory data store in a datacenter. The dataset in Table 1 corresponds to sensor measurement data. The dataset in Table 1 may be stored in column stores in the in-memory data store. As shown, table 1 includes column store "SENSOR ID" 102 that represents the sensor node identifier information; column store "TIMESTAMP" 104 that represents the sensor node timestamp information; column store "MEASUREMENT" 106 representing the sensor node measurement information. In an embodiment, based on a proximity of deployment of the sensor nodes from the datacenter and a data transmission frequency of the sensor nodes, the sensor nodes may transmit the sensor measurement data to the data center. Such sensor measurement data may include different types of data patterns.

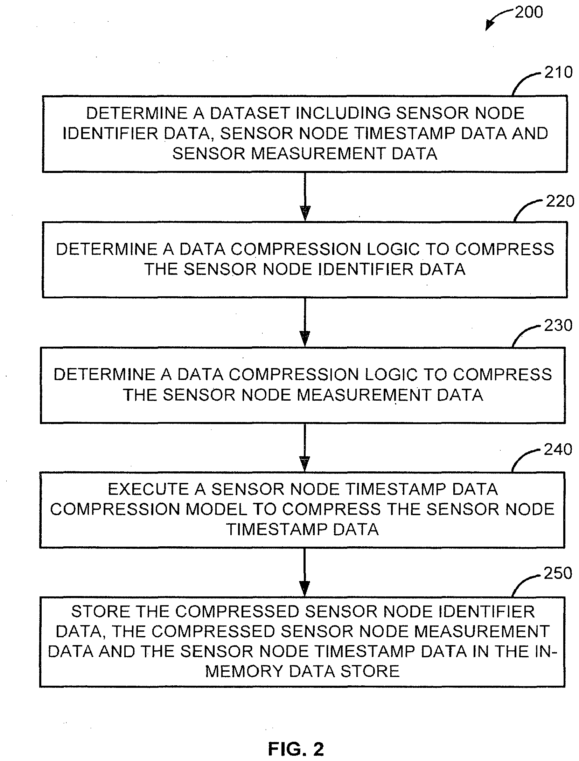

FIG. 2 is a flow diagram illustrating process 200 to compress a dataset, according to an embodiment. Process 200, upon execution compresses dataset associated with sensor data. Based on the attributes associated with the unified dataset. a dataset including sensor node identifier data, sensor node timestamp data and sensor measurement data is determined, at 210. The sensor identifier data, the sensor node timestamp data and the sensor measurement data are determined based on the attributes. To compress the dataset including the sensor data, data compression logic may be determined. The data compression logic may be determined by executing an algorithm or a model.

The data compression logic is determined by executing a suffix tree algorithm. The suffix tree algorithm is executed to determine a data compression logic based on the properties (e.g., type of data pattern, frequency of data transmission from the sensor nodes, etc.) associated with the dataset. A data compression logic (e.g., a first data compression logic) to compress the sensor node identifier data is determined, at 220. A data compression logic (e.g., a second data compression logic) to compress the sensor node measurement data is determined, at 230. A sensor node timestamp data compression model is executed to compress the sensor node timestamp data, at 240. The suffix tree algorithm is executed to determine the data compression logic (e.g., first data compression logic, second data compression logic, etc.). The compressed dataset (e.g., datasets associated with sensor node identifier, sensor node timestamp and sensor measurement) is stored in the in-memory data store, at 250.

**Compression of Sensor Node Identifier Data**

In an embodiment, the sensor nodes may transmit data including sensor node identifier data to a data center. The sensor node identifier data may include multiple different types of data patterns. By way of example, the sensor node identifiers may be represented by integers (e.g., '1', '2', '3', '4', etc.) and may be compressed based on a data compression logic. The data compression logic to compress the sensor node identifier data is based on a determination of the types of data patterns associated with the sensor node identifier data.

The types of data patterns associated with the sensor node identifier data depend on the data transmission frequency from the sensor nodes. Hence, determining the data compression logic (e.g., first data compression logic) to compress the dataset including the sensor node identifier data includes determining data transmission frequency from the multiple sensor nodes. Based on the data transmission frequency, the sensor node identifier data may include multiple types of data patterns (e.g., first type of data pattern, second type of data pattern, and so on). Such types of data patterns may also depend on proximity of deployment of the sensor nodes from the data center.

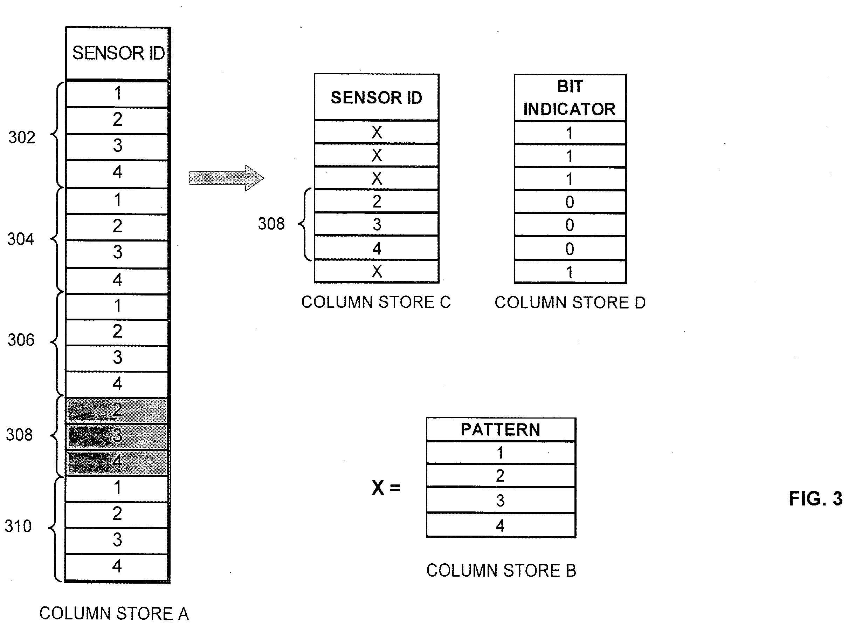

FIG. 3 is a block diagram illustrating compression of sensor node identifier data, according to an embodiment. FIG. 3 shows a column store A including sensor node identifier data. By way of illustration. FIG. 3 shows the column store A stores sensor node identifier data as integers represented by '1', '2', '3', '4', etc. As discussed previously, based on the proximity of deployment of the sensor nodes and the data transmission frequency of the sensor nodes, the data transmitted by the sensor nodes to the data center may include different types of data patterns.

By way of illustration, column store A shows a finite dataset of sensor node identifiers '1234123412342341234'. The column store A including the sensor node identifier dataset may be traversed and the different types of data patterns (e.g., 302, 304, 306, 308 and 310) may be determined. Further, frequently repetitive types of data patterns are determined. By way of example, one such repetitive type of data pattern may include '1234', with a count of 4, since the type of data pattern '1234' occurs 4 times in column store A.

Upon determining the frequently repetitive type of data pattern (e.g., 302, 304, 306 and 310), the data compression logic to compress the dataset is determined. The frequently repetitive type of data pattern may be encoded by a bit-coding scheme or bit-coding logic. In an embodiment, upon encoding the sensor node identifier data, a table including a coded type of data pattern associated with the sensor node identifier and a bit-code indicator may be generated. The bit-coded dataset may represent compressed sensor node identifier dataset.

In an embodiment, an amount of memory utilized or consumed to store sensor node identifier data shown column store A of FIG. 3 may be determined. By way of example, consider that the amount of memory consumed or utilized to store each row or entry of the dataset is 1 byte. Hence, the total amount of memory utilized or consumed to store the dataset of column store A of FIG. 3 may be computed to be equal to 19 bytes (e.g., as there are 19 records or entries in column store A of FIG. 3). Such memory utilization or consumption may be optimized by compressing the sensor node identifier dataset and storing the compressed dataset in the in-memory data store.

In an embodiment, to compress the dataset including the sensor node identifier data, the frequently repetitive type of data pattern (e.g., X of column store B) may be encoded with a bit-coding scheme or bit-coding logic. By way of illustration, column store C and column store D show the bit-coding logic for sensor identifier dataset of column store A of FIG. 3, according to an embodiment. As shown, the frequently repetitive type of data pattern may be determined, encoded and represented by an encoding variable. The encoding of the frequently repetitive type of data pattern may be based on a count (e.g., frequency of occurrence of a type of pattern of data) of the repetitive type of data pattern.

By way of illustration, FIG. 3 shows frequently repetitive type of data pattern is determined as '1234', shown as column store. By way of example, the bit-coding logic may encode such pattern and represent by an encoding variable 'X'. To compress the sensor node identifier dataset, the data compression logic may traverse through the sensor node identifier dataset to determine the occurrence of frequently repetitive type of data pattern. Upon determining an occurrence of the frequently repetitive type of data pattern, the data compression logic may replace the block or interval of dataset associated with the frequently repetitive type of data pattern with the encoding variable 'X'. This is shown as column store C in FIG. 3.

In an embodiment, corresponding to each replaced block of dataset, a value '1' may be stored in the bit-indicator column (e.g., column store D). The value 'I' in the bit-indicator column (e.g., column store D) indicates that the block of dataset corresponds to frequently repetitive type of data pattern and was encoded by the data compression logic. In an embodiment, when the block or interval of dataset (e.g., 308) does not match the frequently repetitive type of data pattern, the data compression logic may store values associated with the sensor node identifiers. By way of illustration, FIG. 3 shows a block or interval dataset 308 that fails to match with the frequently repetitive data pattern (e.g., column store B). In other words, block or interval of dataset 308 may indicate that sensor node with identifier '1' failed to transmit data. In such instances, the corresponding sensor node identifiers are included in the sensor node identifier column (e.g., column store C) and a value '0' may be included in corresponding row in the bit-indicator column (e.g., column store D). In an embodiment, the value '0' in the bit-indicator column (e.g., column store D) may indicate the dataset failed to match with the frequently repetitive type of data pattern (e.g., column store B).

In an embodiment, the dataset including the sensor node identifier data (e.g., column store A of FIG. 3) may be compressed and stored in the in-memory data store. When the sensor node identifier dataset in column store A of FIG. 3 is compressed, the amount of memory utilized or consumed may be computed to be equal to 12 bytes (e.g., frequently repetitive type of data pattern column store = 4 bytes + compressed dataset including the sensor node identifier data column store = 7 bytes + bit indicator column store = 1 byte).

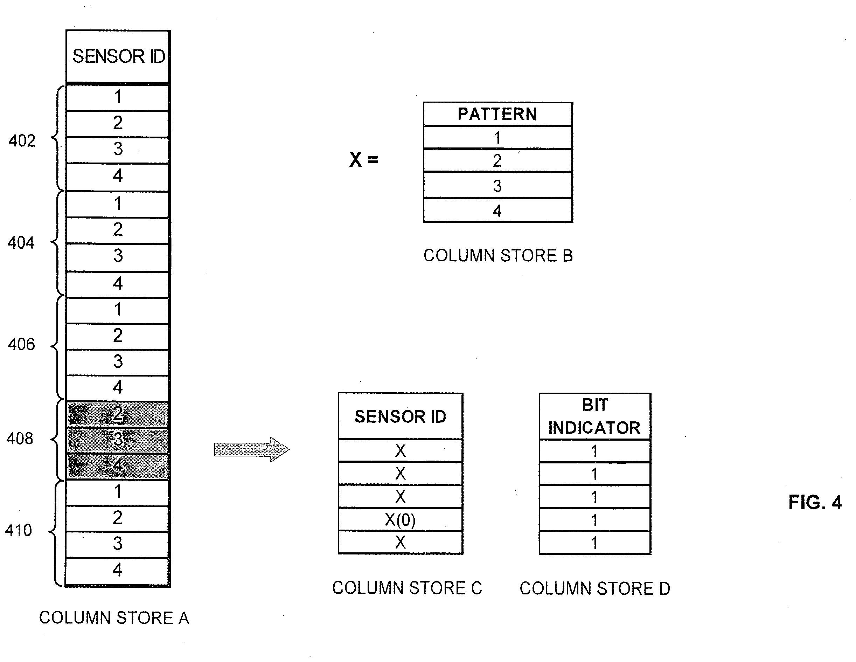

FIG. 4 is a block diagram showing compression of sensor node identifier dataset, according to an embodiment. By way of illustration, column store C and column store D show a bit-coding scheme or bit-coding logic to compress the sensor node identifier dataset. The data compression logic may encode the sensor node identifier dataset as explained previously (e.g., detailed description of FIG. 3). In an embodiment, the data compression logic may determine the position of a missing sensor node identifier in the frequently repetitive type of data pattern and may encode the sensor node identifier dataset using such position information. By way of example, in the frequently repetitive type of data pattern (e.g., column store B), 'X (0)' may indicate the position of missing sensor node with identifier '1'; 'X(1)' may indicate the position of sensor node with identifier '2' and so on.

In an embodiment, the data compression logic may encode the sensor node identifier dataset as shown in column store C and column store D of FIG. 4. By way of illustration, 'X (0)' in the sensor node identifier column store C is encoded and stored with a value '1' in the bit-indicator column store D. Such bit-coding logic may indicate that the corresponding block of sensor node identifier dataset (e.g., 408) partially matches the frequently repetitive type of data pattern (e.g., column store B in FIG. 4). Based on the above bit-coding logic, the value '1' in the bit-indicator column store D associated with the encoded variable 'X (0)' in column store C may indicate that sensor node with. identifier value '1' failed to transmit data.

In an embodiment, the data compression logic may encode sub patterns sequence given in column store B with one element missing (e.g., all possible sub patterns from <'1', '2', '3', '4'> with one missing identifier are <'2', '3', '4'> or <'1', '3', '4'> or <'1', '2', '4'> or <'1', '2', '3'>). In such an instance, the data compression logic may respectively encode the missing sensor node identifier dataset and represent by encoding variables as 'X (0)', 'X (1)', 'X (2)' and 'X (3)' respectively.. In an embodiment, such data compression logic that preserves the original data for recovery may also be referred to as lossless data compression.

In an embodiment, the amount of memory consumed or utilized for storing a compressed dataset corresponding to the each frequently repetitive type of data pattern, may be computed using the equation:

$$\text{Equation (1)}: S = (N * log_2(M) + R_c * log_2(M) + R_c)$$

In the above equation, 'S' represents storage (e.g., in bits) utilized for a type of data pattern in compressed form; 'N' represents number of elements in the pattern; 'M' represents number of unique sensor node identifiers; '$R_c$' represents number of row stores used for storing the compressed data.

In an embodiment, the sensor node identifier dataset may include multiple frequently repetitive types of data patterns. In such a scenario, the storage value 'S' (also referred to as a data compression score) may be computed for each distinct frequently repetitive type of data pattern and the data compression scores may be compared. In an embodiment, the data compression logic may be determined based on a comparison of the data compression scores.

The frequently repetitive type of data patterns is determined by execution of a suffix tree algorithm on the sensor node identifier dataset. The execution of suffix tree algorithm generates a suffix tree (e.g., a suffix tree graph including the sensor node identifier dataset). The suffix tree includes nodes and paths connecting the nodes. In an embodiment, the nodes of the suffix tree may represent a count or number of occurrences of a specific type of data pattern.

In an embodiment, column store A of FIG. 4 may represent a finite dataset. For an infinite dataset (e.g., when count of entries in column store A is in millions or billions), the infinite dataset may be partitioned into finite datasets and frequently repetitive type of data patterns corresponding to each finite dataset may be identified. For each identified frequently type of data pattern in each finite dataset, the data compression scores may be computed, as explained previously. By way of example, the data compression scores for each frequently repetitive type of data patterns may be computed, compared and the data compression logic may be determined.

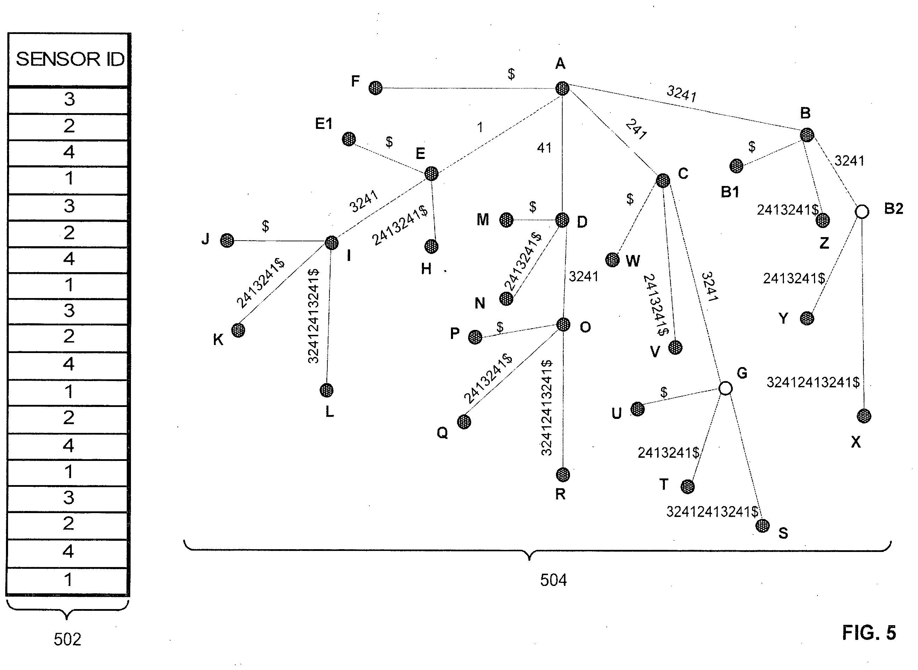

FIG.5 is a block diagram of a suffix tree for sensor node identifier data, according to an embodiment. By way of illustration, FIG. 5 shows a suffix tree graph 504 that is generated for sensor node identifier data 502. As explained previously, the suffix tree graph 504 may be generated by executing the suffix tree algorithm on the sensor node identifier dataset 502. As shown, the suffix tree graph 504 includes nodes (e.g., 'A', 'B', 'D', 'E', 'F', 'G', 'H', 'I', 'J', 'K', 'L', 'M', 'N', 'O', 'P', 'Q', 'R', 'S', 'T', 'U', 'V', 'W'. 'X', 'Y', 'Z'. 'B1', 'B2', 'E1') and paths (e.g., '3241', '$', '241', '41', '1', and so on) connecting the nodes.

In an embodiment, the nodes of the suffix tree may represent a count of occurrences of a particular type of data pattern (e.g., node 'B' would represent a count of 4, since type of data pattern '3241' occurs 4 times in sensor node identifier data 502; node 'C' would represent a count of 5. since the type of data pattern '241' occurs 5 times in sensor node identifier data 502, and so on). The paths connecting the nodes may represent the particular types of data patterns.

To determine the compression logic and optimally compress the sensor node identifier dataset, the suffix tree is traversed to determine non-overlapping nodes. A non-overlapping node may correspond to a mutually exclusive type of data pattern. By way of example, consider node 'I' of FIG. 5, the count of occurrence of type of data pattern '13241' is 2. The first match of type of data pattern (e.g., '13241') starts at $4^{th}$ position (e.g., row index in 502) and ends at $8^{th}$ position (e.g., row index in 502). The second match of type of data pattern starts at $8^{th}$ position (e.g., row index in 502) which overlaps with the occurrence of first match of type of data pattern. The third match of type of data pattern occurs at $15^{th}$ position (e.g., row index in 502) which does not overlap with the occurrence of second match of type of data pattern. Hence, the non-overlapping nodes may be determined as described above.

Upon determining the non-overlapping nodes in the suffix tree, data compression scores (e.g., first data compression score, second data compression score. etc.) for each non-overlapping node may be computed (e.g., using Equation (1)). The data compression score may represent amount of memory utilized or consumed for storing a particular type of data pattern. The data compression logic may be determined based on the data compression scores and the sensor node identifier dataset may be optimally compressed and stored in the in-memory data store.

In an embodiment, the determination of non-overlapping nodes may be iteratively stopped. For instance, the execution of suffix tree algorithm to determine non-overlapping nodes may iteratively stop upon determination of an increase in type of data pattern, as the increase in length of type of data pattern may result in lower data compression scores. By way of example, in FIG. 5, nodes G and B2 would generate higher data compression scores in comparison to the data compression scores of nodes C and B respectively. Node G may be representing a type of data pattern of '2413241' which has a size of 7 bytes. In embodiment, there may be an occurrence of at least two types of patterns in the dataset that includes 19 entries or records. Hence only 14 entries or records may be encoded and 5 records may not be encoded. Hence the amount of memory utilized or consumed by compressed dataset may be computed as: 7 + 2 + 5 = 14 bytes (e.g., without including the bit indicator for type of data pattern '2413241') which would be higher as compared to data compression score for type of data pattern '241' which may be computed as: 3 + 5 + 4 = 13 bytes (e.g., ignoring the bit indicator). The count of occurrence of type of data pattern '241' is 5 (e.g., in 502).

In an embodiment, a structured query language (SQL) query may be received by a data store search engine to search for data. Upon receiving the SQL query, the data store search engine may execute or perform a search in the in-memory data store. For instance, searching the data store may include traversing the compressed sensor node identifier dataset to determine a row index corresponding to the searched data. By way of example, consider the data store search engine receives a SQL query to search for data including sensor node identifier '3'. Upon processing the SQL query, the data store search engine may determine that the searched data is included in the frequently repetitive type of data pattern at $3^{rd}$ position (e.g., X, column store B of FIG. 3).

In an embodiment, the data store search engine may traverse the column store C of FIG. 3 and determine the corresponding value as '1' in bit-indicator column store D of FIG. 3. The row index corresponding to the search may be determined by computing a summation of current row index and the position of sensor node identifier that is being searched. The new current row index is determined in the matching row index list, after which the current row index is updated to the next row index by adding the remaining repetitively data type pattern length. By way of example, consider performing a linear search on column store C, such that first three records are compressed as indicated in column store D and bit indicator of '1'. The position of sensor node identifier '3' may be determined based on the position (e.g., row index) within the frequently repetitive type of data pattern and the size of type of data pattern. Based on such a determination, the position for first three types of data patterns in compressed dataset may be determined as $3^{rd}$, $7^{th}$ and $11^{th}$. It may also be determined that each type of data pattern is of length 4 bytes and hence it may be determined that sensor identifier '2' is at $13^{th}$ position (e.g., 4*3 + 1=13 bytes), as the position is indexed from 1. Further searching in column store C, the sensor node with identifier '3' may be determined to be positioned at row index14 and row index 16. Hence the compressed dataset is including the sensor node identifier '3' may be found at the row index 18.

In an embodiment, upon determining the bit-indicator value as '0', the sensor node identifier is stored in the compressed dataset so that value is compared for match. Upon matching, the current row index is added to the matching row index list and current row index is increment by '1'.

**Compression of Sensor Node Timestamp Data**

In an embodiment, the sensor nodes may transmit data to the datacenter at finite intervals of time. Such data may be referred to as sensor node timestamp data. The sensor node timestamp data may include information such as, sensor node identifier, timestamp data, sensor node measurement data, etc. In an embodiment, the sensor node timestamp data received by the datacenter may be stored in the delta storage associated with the in-memory data store. The sensor node timestamp data may be sorted in an order (e.g., ascending order or descending order) and stored in the delta storage. The sorted sensor timestamp data may be merged with the main storage associated with the in-memory data store by executing a data merge model.

Attributes associated with the sensor node timestamp data are determined. The attributes associated with the sensor node timestamp data may correspond to information, such as a "START TIME", "NUMBER OF INTERVALS", "INTERVAL", "NUMBER OF SENSOR NODES", etc. In an embodiment, information associated with "START TIME" may represent a timestamp (e.g., measurement of time) at which the sensor node performed the measurement. The "START TIME" may be determined by determining the first value in the column store including the timestamp data. The parameter "NUMBER OF SENSOR NODES" may represent the number of unique sensor nodes that may transmit data. Such number may be determined by the sensor node identifiers. The information associated with "INTERVAL" may represent a value including a definite change in time (e.g., in Table 2, integer '1' represents 1 millisecond) by the sensor nodes. The "INTERVAL" may be determined based on a comparison between the sensor node timestamp values for a known instance of timestamp data. The information associated with "NUMBER OF INTERVALS" may represent finite sets of time intervals including a definite type of data pattern associated with the timestamp data. The "NUMBER OF INTERVALS" may be determined by traversing the timestamp data and optimally partitioning into interval blocks based on the timestamp data (e.g., Table 2, number 3 represents three intervals with each sensor measurement with one millisecond measurement for all four sensor nodes).

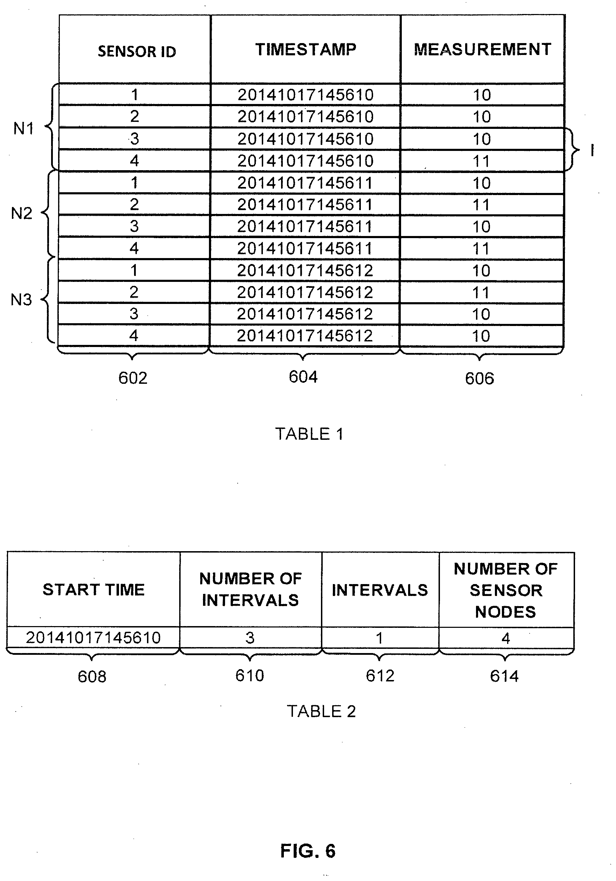

FIG. 6 is a block diagram showing compression of sensor node timestamp data, according to an embodiment. By way of illustration, FIG. 6 shows table 1 including sensor node timestamp data. As shown, table 1 includes sensor node timestamp data includes information such as, sensor node identifier data 602, timestamp data 604 and sensor node measurement data 606. In an embodiment, the sensor node timestamp data may be stored in column stores in the main storage associated with the in-memory data sore. By way of illustration, the column store associated with sensor node identifier data 602 includes integer identifiers, such as '1', '2', '3', and '4.'

In an embodiment, an amount of memory utilized to store the sensor node timestamp data shown in FIG. 6 may be determined. By way of example, the amount of memory consumed or utilized to store each row of data in the sensor node timestamp node is 4 bytes. Hence the total amount of memory utilized to store the sensor node timestamp data of FIG. 6 (e.g., finite size of data) may be computed as 48 bytes (e.g., no. of records or number of entries = 12; amount of memory consumed by each entry or record is 4 bytes.) Such memory utilization or consumption may be reduced by compressing the sensor node timestamp data.

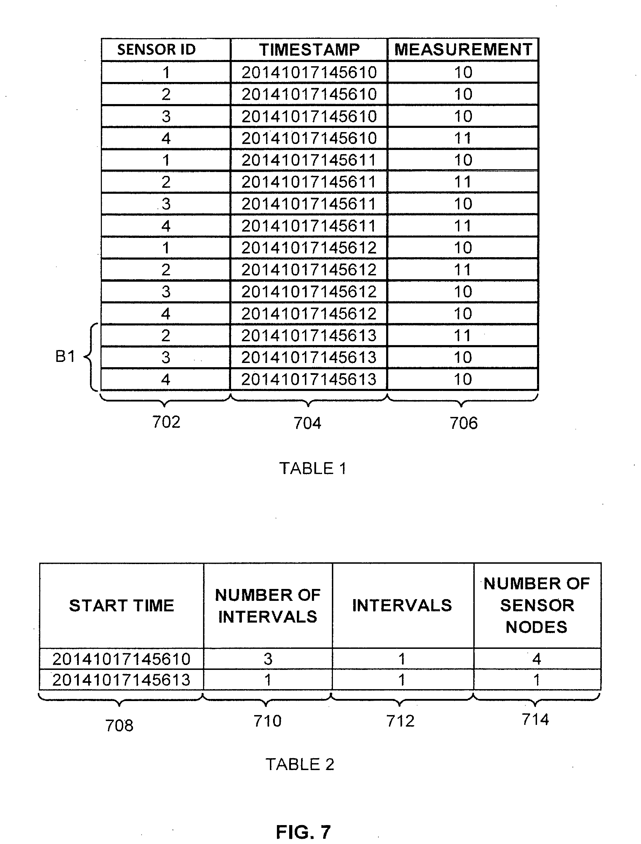

To compress the sensor node timestamp data, the attributes including the information "START TIME" 608, "NUMBER OF INTERVALS" 610, "INTERVAL" 612, "NUMBER OF SENSOR NODES" 614, etc., are determined. Determining the above attributes may correspond to determining the data compression logic. The above attributes may be determined by determining the type of data patterns associated with the sensor node timestamp data. In an embodiment, the sensor node timestamp data may be linearly traversed and may generate compressed dataset upon determining the change in interval between timestamps or a count of number of same timestamps. The change in timestamp is recorded as "INTERVAL" such as 1 millisecond in Table 2 of FIG. 6. In an embodiment, a change in the number of sensor nodes may generate compressed dataset including a row in Table 2 in FIG. 7.

In an embodiment, upon executing linear timestamp algorithm and determining the above attributes, Table 2 of FIG. 6 may be generated. Determining the above attributes may correspond to determining the data compression logic (e.g., sensor node timestamp data compression model) to compress the dataset associated with sensor node timestamp data. Table 2 in FIG. 6 shows attributes that may be determined from Table 1 upon execution of the linear timestamp algorithm. By way of illustration, Table 2 includes: "START TIME" = 20141017145610 608; "NUMBER OF INTERVALS" = 3 610 (e.g., 'N1', 'N2' and 'N3'); "INTERVAL" = 1 612 (e.g., 'I'); "NUMBER OF SENSOR NODES" = 4 614 (e.g., with sensor node identifier1', '2'. '3', and '4'). In an embodiment, the above determined attributes of Table 2 may represent compressed dataset associated with the sensor node timestamp data.

In an embodiment, an amount of memory utilized or consumed by the compressed dataset (e.g., Table 2) may be computed as 7 bytes (e.g., 1*4 bytes corresponding to "START TIME" + 1 byte corresponding to "NUMBER OF INTERVALS" + 1 byte corresponding to "INTERVAL" + 1 byte corresponding to "NUMBER OF SENSOR NODES" = 4). Hence, the amount of memory consumed or utilized to store the sensor node timestamp data may be significantly reduced. For instance, from the above computations, it may be determined that upon compressing the dataset corresponding to the sensor node timestamp data, the amount of memory consumed may be reduced by approximately 85.4 %.

In an embodiment, the amount of memory utilized or consumed by the sensor node timestamp data may be

computed as:

Equation (2):

$$Total\ memory\ utilized\ or\ consumed\ by\ sensor\ node\ timestamp\ data = 4 * M + 3 * M$$

In the equation above, 'M' represents the number of records or entries in the table including the compressed dataset. In an embodiment, when the above determined information (e.g., "NUMBER OF INTERVALS", "INTERVAL", "NUMBER OF SENSOR NODES", etc.) is taken into consideration, a generalized equation may be generated. For instance, the generic form of Equation (2) may be written as:

Equation (3):

$$Total\ memory\ utilized\ or\ consumed\ by\ sesnor\ node\ timestamp\ data = 4 * M + ceil\ (log_2\ I_{max}) * M + ceil\ (log_2\ T_{max}) * M + ceil\ (log_2\ D_{total}) * M$$

In the equation above, 'M' represents number of records or entries; '$I_{max}$' represents maximum "NUMBER OF INTERVALS"; '$T_{max}$' represents maximum "INTERVAL"; '$D_{total}$' represents the maximum "NUMBER OF SENSOR NODES".

FIG. 7 is a block diagram showing compression of sensor node timestamp data. according to embodiment. By way of illustration, FIG. 7 shows table 1 including sensor node timestamp data. As shown, the sensor node timestamp data includes information such as, sensor node identifier data 702, the timestamp data 704 and the sensor node measurement data 706. By way of example, the amount of memory consumed or utilized to store each row of data in the sensor node timestamp node is 4 bytes. Hence the total amount of memory utilized to store the sensor node timestamp data Table 1 of FIG. 7 may be computed as 60 (e.g., no. of records or number of entries = 1.5; amount of memory consumed by each entry or record is 4 bytes.) Such memory utilization or consumption may be reduced by compressing the sensor node timestamp data.

In an embodiment, the attributes (e.g., "START TIME", "NUMBER OF INTERVALS", "INTERVAL", "NUMBER OF SENSOR NODES". etc.,) including the information associated with the sensor node timestamp data may be determined as described in detailed description of FIG. 6. By way of illustration, the attributes associated with sensor node timestamp data of FIG. 7 may be determined and compressed as shown in Table 2 of FIG. 7. By way of illustration, first row of Table 2 in FIG. 7 shows compressed data that includes: "START TIME" = 20141017145610 708; "NUMBER OF INTERVALS" = 3 710; "INTERVAL" = 1 712; "NUMBER OF SENSOR. NODES" = 4 714.

By way of example, consider a scenario where the data center failed to receive data from a sensor node. For instance, consider that sensor node with identifier '1' failed to transmit data to the data center (e.g., on account of faulty sensor node, failed sensor node, failed communication link between the sensor node and the datacenter, etc.). By way of illustration, Table 1 in FIG, 7 shows such dataset corresponding to the last interval block (e.g.. 'B1') and associated with timestamp data '20141017145613'. In such a scenario, the dataset may be compressed and stored as shown in second row of Table 2 in FIG. 7. In an embodiment, the second row of Table 2 in FIG. 7 indicates that information associated with timestamp data '20141017145613' and sensor node with identifier '1' failed to transmit data to the data center. Such a technique or mechanism of data compression of the sensor node timestamp data may be referenced as lossless compression as the original dataset including the timestamp data may be recovered from compressed data.

In an embodiment, the amount of memory utilized or consumed to store compressed dataset of Table 2 in FIG. 7 may be computed using Equation (2). The amount of memory consumed is computed to be equal to 14 bytes (e.g., 4 * 2 + 3 * 2). Hence, the amount of memory consumed or utilized to store the sensor node timestamp data may be significantly reduced. For instance, from the above computations, it may be determined that upon compressing the dataset corresponding to the sensor node timestamp data, the amount of memory consumed may be reduced by approximately 76.7 %.

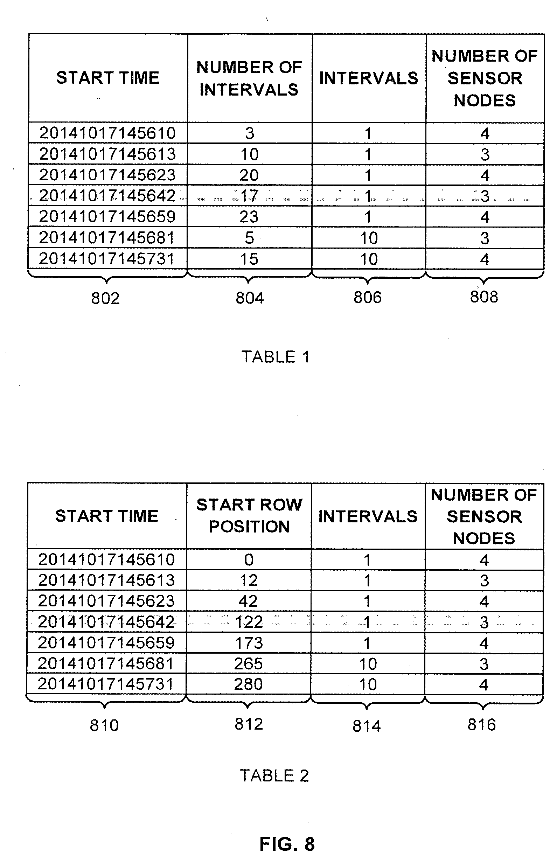

FIG. 8 is a block diagram showing tables including compressed dataset for sensor node timestamp data, according to an embodiment. By way of example, consider that number of records or entries in a table including sensor node timestamp data is 341. Hence the total amount of memory utilized to store the sensor node timestamp data may be computed as 1364 bytes (e.g., no. of records or entries = 341; amount of memory consumed by each entry or record is 4 bytes.) Such memory utilization or consumption may be reduced by compressing the sensor node timestamp data.

In an embodiment, the dataset corresponding to the senor timestamp data may be compressed as explained previously (e.g., detailed description of FIG. 6 and FIG. 7). By way of illustration, Table 1 in FIG. 8 shows compressed dataset associated with the sensor node timestamp data. In an embodiment, the compressed dataset corresponding to the sensor node timestamp data as shown in Table 1 of FIG. 8 corresponds to different values of "START TIME" 802. Table 1 also includes information related to corresponding information, such as "NUMBER OF INTERVALS" 804, "INTERVALS" 806 and "NUMBER OF SENSOR NODES" 808.

In an embodiment, the amount of memory utilized or consumed to store the compressed dataset as shown in Table 1 of FIG. 8 may be computed and is equal to 98 bytes (e.g., 4*7 +4*7 + 4*7 +2*7). Hence, the amount of memory consumed or utilized to store the sensor node timestamp data may be significantly reduced. For instance, from the above computations, it may be determined that upon compressing the dataset corresponding to the sensor node timestamp data, the amount of memory consumed may be reduced by approximately 92.81 %.

In an embodiment, the dataset corresponding to the senor timestamp data may be compressed as explained previously (e.g., detailed description of FIG. 6 and FIG. 7). By way of illustration, Table 2 in FIG. 8 shows compressed dataset associated with the sensor node timestamp data for different values of "START TIME" 810. In an embodiment, Table 2 in FIG. 8 shows column store including the row index (e.g., "START ROW POSITION" 812). The row index corresponds to start position of the timestamp in the original table (e.g., 704, of Table 1 in FIG 7). Table 2 also includes the column store "INTERVALS" 814 and "NUMBER OF SENSOR NODES" 816.

In an embodiment, the amount of memory utilized or consumed to store the compressed dataset as shown in Table 2 of FIG. 8 may be computed and is equal to 98 bytes (e.g., 4*7 +4*7 + 4*7 +2*7). Hence, the amount of memory consumed or utilized to store the sensor node timestamp data may be significantly reduced. For instance, from the above computations, it may be determined that upon compressing the dataset corresponding to the sensor node timestamp data, the amount of memory consumed may be reduced by approximately 92.81 %.

In an embodiment, a process to search the compressed dataset including the sensor node timestamp data may be optimized. The process of optimizing the search may include determining the searched dataset using a row index (e.g., a start row index 'R$_s$'). For instance, consider the dataset is compressed and stored in the in-memory data store as shown in Table 1 of FIG. 8. By way of example, consider executing or performing a search on Table 1 in FIG. 8, Consider the search query includes searching for the dataset including the timestamp data '20141017145650.'

In an embodiment, a data store search engine may process the query to search for the dataset. In an embodiment, upon traversing through the column store of the compressed timestamp data (802 of Table 1 in FIG 8.), the data store search engine may determine and select a row (e.g., in Table 1 of FIG. 8, 4$^{th}$ row is selected (shown as shaded row), since the timestamp data in 4$^{th}$ row is 20141017145642' and the searched timestamp data is '20141017145650').

In an embodiment, the business logic for selecting the row may include performing a binary search on the column store including the timestamp data. The binary search process may include determining a start time based on timestamp data. The process of binary search is terminated upon determining the timestamp data that is less than or equal to the searched timestamp data and the next timestamp in compressed data (804 of Table 1 in FIG 8.) is greater than searched timestamp.

In an embodiment, the start row index ('R$_s$') corresponding to the searched timestamp data '20141017145650' may be determined based on a business logic. For instance, the business logic may include determining a row index before the selected row. Such a row index may be referred to as a row index before computation, 'R$_b$', which may be determined using the equation:

$$\text{Equation (4): } R_b = \sum_{i=1}^{K} I_i * D_i$$

In the equation above, 'i' represents the row index (4$^{th}$ row in reference to the above example); 'K' represents number of rows before the selected row; 'I$_i$' represents the "NUMBER OF INTERVALS" and 'Di' represents the "NUMBER OF SENSOR NODES."

In an embodiment, the business logic may further include determining a row index within the selected row. Such a row index may be referred to as row index within the selected row. 'R$_w$' which may be determined using the equation:

$$\text{Equation (5): } Rw = \frac{(T - T_s)}{T_t} * D_s$$

In the equation above, 'T' represents the searched timestamp data; 'Ts' represents the timestamp data of the selected 's' row; 'Ds' represents the number of sensor nodes corresponding to the selected 's' row; $T_t$, represents the time "INTERVAL" of sensor node corresponding to the selected 's' row.

In embodiment, 'R$_s$' may be determined using the equation:

$$\text{Equation (6): } Rs = R_b + Rw$$

Using the above equations, 'R$_s$' for the above searched timestamp data may be computed as: R$_b$ = 122 (e.g., 3*4 + 10*3 + 20*4); R$_w$ = 24 (e.g., (20141017145650 - 20141017145642)/1 * 3); R$_s$ = 146 (e.g., 122 + 24).

In an embodiment, since D$_s$ = 3, the data store search engine may determine that the row index range corresponding to the searched timestamp data '20141017145650' is 146, 147 and 148(since the number of sensor nodes = D$_s$ = 3 and INTERVAL = $T_I$ = 1 *milliseconds*).

By way of example, consider that the timestamp data '20141017145650' may be searched in Table 2 of FIG. 8. In an embodiment, upon traversing through the column store including the timestamp data, the data store search engine may determine and select a row (e.g., in Table 2 of FIG. 8, 4$^{th}$ row is selected (shown as shaded row), since the timestamp data in 4$^{th}$ row is '20141017145642' and the searched timestamp data is '20141017145650'). In case of Table 2 of FIG. 8 we directly get the R$_b$ (example value 122 in Table 2 FIG. 8 shaded row) and R$_w$ is computed as above (as we did in Table 1, FIG. 8 case, e.g., (20141017145650 - 20141017145642)/1 * 3=24). As explained above, the row index range for the timestamp data '20141017145650' may be determined to be 146, 147 and 148 (since the number of sensor nodes = D$_s$ = 3 and time INTERVAL= $T_I$ = 1 *milliseconds).*

## Compression of Sensor Node Measurement Data

A dataset including sensor measurement data is compressed and stored in an in-memory data store. The sensor measurement data may include measurements recorded by the sensor nodes. By way of example, the sensor measurement data may correspond to measurements, such as, pressure, temperature, weight, capacity/volume, etc. The dataset including the sensor measurement data is compressed by executing a sensor measurement data compression model (e.g., sensor measurement data compression algorithms). The sensor measurement data may be compressed using compression techniques such as, run-length encoding, cluster coding, dictionary coding, etc.

In an embodiment, the dataset including the sensor measurement data may be compressed using the suffix tree algorithms and techniques (e.g., compression of sensor node identifier data). Data compression may have advantages such as, reduced data volumes that may require less main memory or hard disk capacity, reduced data flows, lower demands on processor architectures, network bandwidth, etc.

Some embodiments may include the above-described methods being written as one or more software components. These components, and the functionality associated with each, may be used by client, server, distributed, or peer computer systems. These components may be written in a computer language corresponding to one or more programming languages such as, functional, declarative, procedural, object-oriented, lower level languages and the like. They may be linked to other components via various application programming interfaces and then compiled into one complete application for a server or a client. Alternatively, the components maybe implemented in server and client applications. Further, these components may be linked together via various distributed programming protocols. Some example embodiments may include remote procedure calls being used to implement one or more of these components across a distributed programming environment. For example, a logic level may reside on a first computer system that is remotely located from a second computer system containing an interface level (e.g., a graphical user interface). These first and second computer systems can be configured in a server-client, peer-to-peer, or some other configuration. The clients can vary in complexity from mobile and handheld devices, to thin clients and on to thick clients or even other servers.

The above-illustrated software components are tangibly stored on a computer readable storage medium as instructions. The term "computer readable storage medium" should be taken to include a single medium or multiple media that stores one or more sets of instructions. The term "computer readable storage medium" should be taken to include any physical article that is capable of undergoing a set of physical changes to physically store, encode, or otherwise carry a set of instructions for execution by a computer system which causes the computer system to perform any of the methods or process steps described, represented, or illustrated herein. A computer readable storage medium may be a tangible computer readable storage medium. A computer readable storage medium may be a non-transitory computer readable storage medium. Examples of a non-transitory computer readable storage media include, but are not limited to: magnetic media, such as hard disks, floppy disks, and magnetic tape; optical media such as CD-ROMs, DVDs and holographic devices; magneto-optical media; and hardware devices that are specially configured to store and execute, such as application-specific integrated circuits ("ASICs"), programmable logic devices ("PLDs") and ROM and RAM devices. Examples of computer readable instructions include machine code, such as produced by a compiler, and files containing higher-level code that are executed by a computer using an interpreter. For example, an embodiment may be implemented using Java, C++, or other object-oriented programming language and development tools. Another embodiment may be implemented in hard-wired circuitry in place of, or in combination with machine readable software instructions.

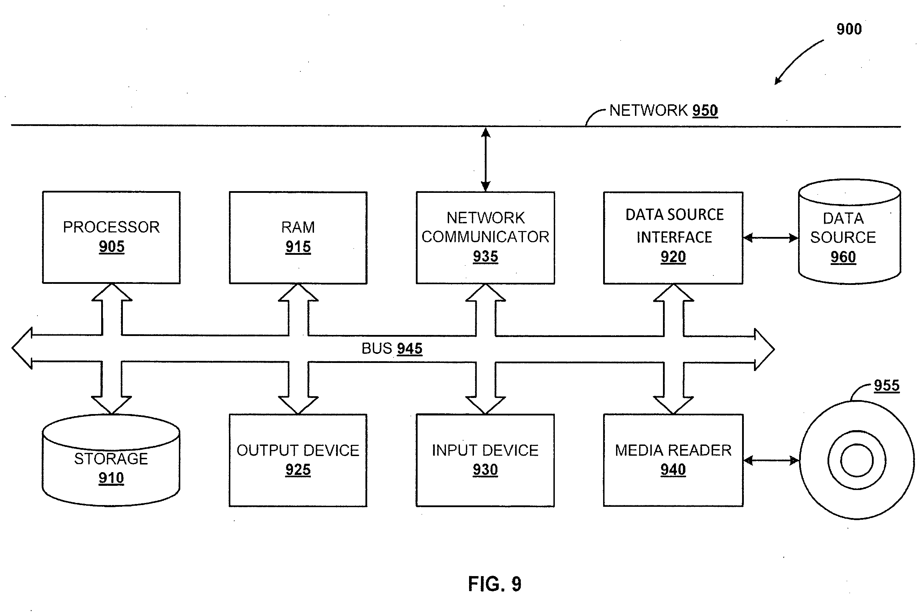

FIG. 9 is a block diagram of an exemplary computer system 900, according to an embodiment. Computer system 900 includes processor 905 that executes software instructions or code stored on computer readable storage medium 955 to perform the above-illustrated methods. Processor 905 can include a plurality of cores. Computer system 900 includes media reader 940 to read the instructions from computer readable storage medium 955 and store the instructions in storage 910 or in random access memory (RAM) 915. Storage 910 provides a large space for keeping static data where at least some instructions could be stored for later execution. According to some embodiments, such as some in-memory computing system embodiments, RAM 915 can have sufficient storage capacity to store much of the data required for processing in RAM 915 instead of in storage 910. In some embodiments, all of the data required for processing may be stored in RAM 915. The stored instructions may be further compiled to generate other representations of the instructions and dynamically stored in RAM 915. Processor 905 reads instructions from RAM 915 and performs actions as instructed. According to one embodiment, computer system 900 further includes output device 925 (e.g., a display) to provide at least some of the results of the execution as output including, but not limited to, visual information to users and input device 930 to provide a user or another device with means for entering data and/or otherwise interact with computer system 900. Each of these output devices 925 and input devices 930 could be joined by one or more additional peripherals to further expand the capabilities of computer system 900. Network communicator 935 may be provided to connect computer system 900 to network 950 and in turn to other devices connected to network 950 including other clients, servers, data stores, and interfaces, for instance. The modules of computer system 900 are interconnected via bus 945. Computer system 900 includes a data source interface 920 to access data source 960. Data source 960 can be accessed via one or more abstraction layers implemented in hardware or software. For example, data source 960 may be accessed by network 950. In some embodiments data source 960 may be accessed via an abstraction layer, such as, a semantic layer.

A data source is an information resource. Data sources include sources of data that enable data storage and retrieval. Data sources may include databases, such as, relational, transactional, hierarchical, multi-dimensional (e.g., OLAP), object oriented databases, and the like. Further data sources include tabular data (e.g., spreadsheets, delimited text files), data tagged with a markup language (e.g., XML data), transactional data, unstructured data (e.g., text files, screen scrapings), hierarchical data (e.g., data in a file system, XML data), files, a plurality of reports, and any other data source accessible through an established protocol, such as, Open Data Base Connectivity (ODBC), produced by an underlying software system (e.g., ERP system), and the like. Data sources may also include a data source where the data is not tangibly stored or otherwise ephemeral such as data streams, broadcast data, and the like. These data sources can include associated data foundations, semantic layers, management systems, security systems and so on.

In the above description, numerous specific details are set forth to provide a thorough understanding of embodiments. One skilled in the relevant art will recognize, however that the embodiments can be practiced without one or more of the specific details or with other methods, components, techniques, etc. In other instances, well-known operations or structures are not shown or described in details.

Although the processes illustrated and described herein include series of steps, it will be appreciated that the different embodiments are not limited by the illustrated ordering of steps, as some steps may occur in different orders, some concurrently with other steps apart from that shown and described herein. In addition, not all illustrated steps may be required to implement a methodology in accordance with the one or more embodiments. Moreover, it will be appreciated that the processes may be implemented in association with the apparatus and systems illustrated and described herein as well as in association with other systems not illustrated.

The above descriptions and illustrations of embodiments, including what is described in the Abstract, is not intended to be exhaustive or to limit the one or more embodiments to the precise forms disclosed. Rather, the scope is to be determined by the following claims, which are to be interpreted in accordance with established doctrines of claim construction.

**Claims**

1. A computer-implemented method to compress a dataset, comprising:

   receiving the dataset at a particular frequency and at particular time intervals from sensor nodes;
   based on one or more attributes of data associated with a unified dataset stored in an in-memory data store, determining a dataset including sensor node identifier data (102; 502; 602; 702), sensor node timestamp data (104; 604; 704) and sensor measurement data (106; 606; 706);
   determining a first data compression logic;
   compressing the sensor node identifier data (102; 502; 602; 702) based on the first data compression logic; and
   determining a second data compression logic;
   compressing the sensor measurement data (106; 606; 706) based on the second data compression logic;
   executing a sensor node timestamp data compression model to compress the sensor node timestamp data (104; 604; 704); and
   storing the compressed sensor node identifier data (102; 502; 602; 702), the compressed sensor measurement data (106; 606; 706) and the compressed sensor node timestamp data (104; 604; 704) in the in-memory data store;

wherein determining the first data compression logic, comprises:

based on the data transmission frequency from a plurality of sensor nodes (A-Z), determining one or more types of data patterns associated with the sensor node identifier data (102; 502; 602; 702); and
from the determined one or more type of data patterns, determining at least one frequently repetitive type of data pattern;
wherein determining the sensor node timestamp data compression model, comprises: determining attributes associated with the sensor node timestamp data including start time, the count of number of intervals (610; 710; 804), interval duration and number of sensor nodes,
wherein determining the the at least one frequently repetitive type of data pattern comprises:

executing a suffix tree algorithm for generating a suffix tree (504) to determine a data compression logic, the suffix tree (504) including the sensor node identifier data (102; 502; 602; 702), the suffix tree (504) including a plurality of nodes (A-Z) and a plurality of paths connecting the plurality of nodes (A-Z);
traversing the suffix tree (504) and determining one or more non-overlapping nodes from the plurality of nodes (A-Z);
for the determined one or more non-overlapping nodes, computing data compression scores corresponding to the one or more non-overlapping nodes; and
based on a comparison of the computed data compression scores, determining the first data compression logic.

2. The computer-implemented method of any one of the preceding claims, wherein determining the second data compression logic, comprises:

based on a data transmission frequency from the plurality of sensor nodes (A-Z), determining one or more types of data patterns associated with the sensor measurement data (106; 606; 706); and
from the determined one or more type of data patterns, determining at least one frequently repetitive type of data pattern.

3. The computer implemented method of any one of the preceding claims, wherein determining the start time, the count of number of intervals (610; 710; 804), the interval duration and the number of sensor nodes is based on a sorted timestamp information and a data transmission frequency from a plurality of sensor nodes (A-Z).

4. The computer implemented method of any one of the preceding claims, further comprising:
upon determining the first data compression logic, encoding the dataset including the sensor identifier data by a bit-coding logic to compress the dataset corresponding to the sensor node identifier data (102; 502; 602; 702).

5. The computer-implemented method of any one of the preceding claims, wherein the compressed dataset is optimized to search for data.

6. The computer-implemented method of any one of the preceding claims, further comprising:

receiving the dataset including sensor node identifier data (102; 502; 602; 702), sensor node timestamp data (104; 604; 704) and sensor measurement data (106; 606; 706) from the plurality of sensor nodes (A-Z);
storing the received dataset in a delta storage associated with the in-memory data store; and
upon sorting the dataset based on a timestamp information, merging the dataset stored in the delta storage with a main storage associated with the in-memory data store.

7. A computer system to compress a dataset, comprising:

a memory storing computer instructions; and
a processor (905) communicatively coupled with the memory to execute the instructions according to the method steps of any one of claims 1 to 6 .

8. A non-transitory computer-readable storage medium (955) tangibly storing instructions, which when executed by a computer, cause the computer to execute operations comprising the method steps of any one of claims 1 to 6 .

9. The non-transitory computer-readable storage medium (955) of claim 8 , wherein determining the second data compression logic, comprises:

    determining one or more types of data patterns associated with sensor node timestamp data (104; 604; 704) based on a sorted timestamp information and a data transmission frequency from a plurality of sensor nodes (A-Z);
    from the determined one or more types of data patterns associated with sensor node timestamp data (104; 604; 704), determining a start time, a count of a number of intervals (610; 710; 804), one or more intervals and number of sensor nodes (614; 714; 808, 816); and
    based on the determined start time, the count of number of intervals (610; 710; 804), one or more intervals and the number of sensor nodes, compressing the dataset including the sensor node timestamp data (104; 604; 704).

**Patentansprüche**

1. Ein computerimplementiertes Verfahren zum Komprimieren eines Datensatzes, das Folgendes umfasst:

    Empfangen des Datensatzes mit einer bestimmten Frequenz und in bestimmten Zeitintervallen von Sensorknoten;
    auf der Grundlage eines oder mehrerer Attribute von Daten, die mit einem vereinheitlichten Datensatz verknüpft sind, der in einem speicherinternen Datastore gespeichert ist, Bestimmen eines Datensatzes, der Sensorknoten-Kennungsdaten (102; 502; 602; 702), Sensorknoten-Zeitstempeldaten (104; 604; 704) und Sensormessdaten (106; 606; 706) beinhaltet;
    Bestimmen einer ersten Datenkompressionslogik;
    Komprimieren der Sensorknoten-Kennungsdaten (102; 502; 602; 702) auf der Grundlage der ersten Datenkompressionslogik; und
    Bestimmen einer zweiten Datenkompressionslogik;
    Komprimieren der Sensormessdaten (106; 606; 706) auf der Grundlage der zweiten Datenkompressionslogik;
    Ausführen eines Sensorknoten-Zeitstempel-Datenkompressionsmodells zum Komprimieren der Sensorknoten-Zeitstempeldaten (104; 604; 704); und
    Speichern der komprimierten Sensorknoten-Kennungsdaten (102; 502; 602; 702), der komprimierten Sensormessdaten (106; 606; 706) und der komprimierten Sensorknoten-Zeitstempeldaten (104; 604; 704) im speicherinternen Datastore; wobei das Bestimmen der ersten Datenkompressionslogik Folgendes umfasst:

        auf der Grundlage der Datenübertragungsfrequenz von einer Vielzahl von Sensorknoten (A-Z), Bestimmen eines oder mehrerer Typen von Datenmustern, die mit den Sensorknoten-Kennungsdaten (102; 502; 602; 702) verknüpft sind; und
        aus dem bestimmten einen oder mehreren Typen von Datenmustern, Bestimmen mindestens eines sich häufig wiederholenden Datenmustertyps;

    wobei das Bestimmen des Sensorknoten-Zeitstempeldaten-Kompressionsmodells Folgendes umfasst: Bestimmen von Attributen, die mit den Sensorknoten-Zeitstempeldaten verknüpft sind und die Folgendes beinhalten: die Startzeit, die Anzahl der Intervalle (610; 710; 804), die Intervalldauer und die Anzahl der Sensorknoten,
    wobei das Bestimmen des mindestens einen sich häufig wiederholenden Datenmustertyps Folgendes umfasst:

        Ausführen eines Suffixbaum-Algorithmus zum Erzeugen eines Suffixbaums (504), um eine Datenkompressionslogik zu bestimmen, wobei der Suffixbaum (504) die Sensorknoten-Kennungsdaten (102; 502; 602; 702) beinhaltet, wobei der Suffixbaum (504) eine Vielzahl von Knoten (A-Z) und eine Vielzahl von Pfaden, die die Vielzahl von Knoten (A-Z) verbinden, beinhaltet;
        Durchlaufen des Suffixbaums (504) und Bestimmen eines oder mehrerer nicht überlappender Knoten aus der Vielzahl von Knoten (A-Z);
        für den oder die bestimmten nicht überlappenden Knoten, Berechnen von Datenkompressions-Scores, die dem einen oder den mehreren nicht überlappenden Knoten entsprechen; und
        auf der Grundlage eines Vergleichs der berechneten Datenkompressions-*Scores,* Bestimmen der ersten Datenkompressionslogik.

2. Das computerimplementierte Verfahren nach irgendeinem der vorstehenden Ansprüche, wobei das Bestimmen der zweiten Datenkompressionslogik Folgendes umfasst:

basierend auf einer Datenübertragungsfrequenz von der Vielzahl von Sensorknoten (A Z), Bestimmen eines oder mehrerer Typen von Datenmustern, die mit den Sensormessdaten (106; 606; 706) verknüpft sind; und aus dem bestimmten einen oder mehreren Typen von Datenmustern, Bestimmen mindestens eines sich häufig wiederholenden Datenmustertyps.

**3.** Das computerimplementierte Verfahren nach irgendeinem der vorstehenden Ansprüche, wobei das Bestimmen der Startzeit, der Anzahl von Intervallen (610; 710; 804), der Intervalldauer und der Anzahl von Sensorknoten auf einer sortierten Zeitstempelinformation und einer Datenübertragungsfrequenz von einer Vielzahl von Sensorknoten (A Z) basiert.

**4.** Das computerimplementierte Verfahren nach irgendeinem der vorstehenden Ansprüche, das ferner Folgendes umfasst:
nach dem Bestimmen der ersten Datenkompressionslogik, Codieren des Datensatzes, der die Sensorkennungsdaten beinhaltet, durch eine Bitcodierungslogik, um den Datensatz zu komprimieren, der den Sensorknoten-Kennungsdaten (102; 502; 602; 702) entspricht.

**5.** Das computerimplementierte Verfahren nach irgendeinem der vorstehenden Ansprüche, wobei der komprimierte Datensatz für die Suche nach Daten optimiert ist.

**6.** Das computerimplementierte Verfahren nach irgendeinem der vorstehenden Ansprüche, das ferner Folgendes umfasst:

Empfangen des Datensatzes, der Folgendes beinhaltet: Sensorknoten-Kennungsdaten (102; 502; 602; 702), Sensorknoten-Zeitstempeldaten (104; 604; 704) und Sensormessdaten (106; 606; 706), von der Vielzahl von Sensorknoten (A-Z);
Speichern des empfangenen Datensatzes in einem Delta-Speicher, der mit dem speicherinternen Datastore verbunden ist; und
nach dem Sortieren des Datensatzes auf der Grundlage einer Zeitstempelinformation, Zusammenführen des im Delta-Speicher gespeicherten Datensatzes mit einem mit dem speicherinternen Datastore verknüpften Hauptspeicher.

**7.** Ein Computersystem zum Komprimieren eines Datensatzes, das Folgendes umfasst:

einen Speicher, der Computeranweisungen speichert; und
einen Prozessor (905), der kommunikativ mit dem Speicher gekoppelt ist, um die Anweisungen gemäß den Verfahrensschritten nach irgendeinem der Ansprüche von 1 bis 6 auszuführen.

**8.** Ein nicht-flüchtiges, computerlesbares Speichermedium (955), das Anweisungen speichert, die, wenn sie von einem Computer ausgeführt werden, den Computer veranlassen, Operationen auszuführen, die die Verfahrensschritte nach irgendeinem der Ansprüche von 1 bis 6 umfassen.

**9.** Das nicht-flüchtige computerlesbare Speichermedium (955) nach Anspruch 8, wobei
das Bestimmen der zweiten Datenkompressionslogik Folgendes umfasst:

Bestimmen eines oder mehrerer Typen von Datenmustern, die mit Sensorknoten-Zeitstempeldaten (104; 604; 704) verknüpft sind, basierend auf einer sortierten Zeitstempelinformation und einer Datenübertragungsfrequenz von einer Vielzahl von Sensorknoten (A-Z);
aus dem bestimmten einen oder mehreren Typen von Datenmustern, die mit Sensorknoten-Zeitstempeldaten (104; 604; 704) verknüpft sind, Bestimmen einer Startzeit, einer Zählung einer Anzahl von Intervallen (610; 710; 804), eines oder mehrerer Intervalle und einer Anzahl von Sensorknoten (614; 714; 808, 816); und
basierend auf der bestimmten Startzeit, der Zählung der Anzahl von Intervallen (610; 710; 804), einem oder mehreren Intervallen und der Anzahl von Sensorknoten, Komprimieren des Datensatzes, der die Sensorknoten-Zeitstempeldaten (104; 604; 704) beinhaltet.

**Revendications**

**1.** Un procédé mis en œuvre par ordinateur pour compresser un ensemble de données, comprenant le fait de :

recevoir l'ensemble de données à une fréquence particulière et à des intervalles de temps particuliers à partir de nœuds de capteurs ;

sur la base d'un ou plusieurs attributs de données associés à un ensemble de données unifié stocké dans un magasin de données en mémoire, déterminer un ensemble de données incluant des données d'identification de nœud de capteur (102 ; 502 ; 602 ; 702), des données d'horodatage de nœud de capteur (104 ; 604 ; 704) et des données de mesure de capteur (106 ; 606 ; 706) ;

déterminer une première logique de compression de données ;

compresser les données d'identification de nœud de capteur (102 ; 502 ; 602 ; 702) sur la base de la première logique de compression de données ; et

déterminer une deuxième logique de compression de données ;

compresser les données de mesure du capteur (106 ; 606 ; 706) sur la base de la deuxième logique de compression de données ;

exécuter un modèle de compression de données d'horodatage de nœud de capteur pour compresser les données d'horodatage de nœud de capteur (104 ; 604 ; 704) ; et de

stocker les données d'identification de nœud de capteur compressées (102 ; 502 ; 602 ; 702), les données de mesure de capteur compressées (106 ; 606 ; 706) et les données d'horodatage de nœud de capteur compressées (104 ; 604 ; 704) dans le magasin de données en mémoire ;

sachant que le fait de déterminer la première logique de compression de données comprend le fait de :

sur la base de la fréquence de transmission de données à partir d'une pluralité de nœuds de capteur (A-Z), déterminer un ou plusieurs types de motifs de données associés aux données d'identification de nœud de capteur (102 ; 502 ; 602 ; 702) ; et de

à partir du ou des types de motifs de données déterminés, déterminer au moins un type de modèle de données fréquemment répétitif ;

sachant que le fait de déterminer le modèle de compression de données d'horodatage de nœud de capteur comprend le fait de : déterminer des attributs associés aux données d'horodatage de nœud de capteur, incluant : l'heure de début, le compte du nombre d'intervalles (610 ; 710 ; 804), la durée d'intervalle et le nombre de nœuds de capteur,

sachant que le fait de déterminer l'au moins un type de modèle de données fréquemment répétitif comprend les étapes suivantes :

exécuter un algorithme d'arbre de suffixes pour générer un arbre de suffixes (504) afin de déterminer une logique de compression de données, l'arbre de suffixes (504) incluant les données d'identification de nœud de capteur (102 ; 502 ; 602 ; 702), l'arbre de suffixes (504) incluant une pluralité de nœuds (A-Z) et une pluralité de chemins connectant la pluralité de nœuds (A-Z) ;

traverser l'arbre de suffixes (504) et déterminer à partir de la pluralité de nœuds (A-Z) un ou plusieurs nœuds qui ne se chevauche pas;

pour le ou les nœuds non chevauchants déterminés, calculer des scores de compression de données correspondant au ou aux nœuds non chevauchants ; et

sur la base d'une comparaison des scores de compression de données calculés, déterminer la première logique de compression de données.

2. Le procédé mis en œuvre par ordinateur d'après l'une quelconque des revendications précédentes, sachant que le fait de déterminer la deuxième logique de compression de données comprend le fait de :

sur la base d'une fréquence de transmission de données provenant de la pluralité de nœuds de capteur (A-Z), déterminer un ou plusieurs types de motifs de données associés aux données de mesure de capteur (106 ; 606 ; 706) ; et de

à partir du ou des types de motifs de données déterminés, déterminer au moins un type de modèle de données fréquemment répétitif.

3. Le procédé mis en œuvre par ordinateur d'après l'une quelconque des revendications précédentes, sachant que le fait de déterminer l'heure de début, le compte du nombre d'intervalles (610 ; 710 ; 804), la durée de l'intervalle et le nombre de nœuds de capteur est basé sur des informations d'horodatage triées et une fréquence de transmission de données provenant d'une pluralité de nœuds de capteur (A-Z).

4. Le procédé mis en œuvre par ordinateur d'après l'une quelconque des revendications précédentes, comprenant en outre le fait de : lors de la détermination de la première logique de compression de données, coder l'ensemble de données incluant les données d'identification de capteur par une logique de codage de bits afin de compresser l'ensemble de données correspondant aux données d'identification de nœud de capteur (102 ; 502 ; 602 ; 702).

5. Le procédé mis en œuvre par ordinateur d'après l'une quelconque des revendications précédentes, sachant que l'ensemble de données compressé est optimisé pour rechercher des données.

6. Le procédé mis en œuvre par ordinateur d'après l'une quelconque des revendications précédentes, comprenant en outre le fait de :

recevoir l'ensemble de données incluant des données d'identification de nœud de capteur (102 ; 502 ; 602 ; 702), des données d'horodatage de nœud de capteur (104 ; 604 ; 704) et des données de mesure de capteur (106 ; 606 ; 706) provenant de la pluralité de nœuds de capteur (A-Z) ;
stocker l'ensemble de données reçues dans un stockage delta associé au magasin de données en mémoire ; et de
lors du tri de l'ensemble de données sur la base d'une information d'horodatage, fusionner l'ensemble de données stocké dans la mémoire delta avec une mémoire principale associée au magasin de données en mémoire.

7. Un système informatique pour compresser un ensemble de données, comprenant :

une mémoire stockant des instructions informatiques ; et
un processeur (905) couplé de manière communicative avec la mémoire pour exécuter les instructions conformes aux étapes du procédé d'après l'une quelconque des revendications de 1 à 6.

8. Un support de stockage (955) non transitoire lisible par ordinateur stockant de manière tangible des instructions, qui, lorsqu'elles sont exécutées par un ordinateur, amènent l'ordinateur à exécuter des opérations comprenant les étapes du procédé d'après l'une quelconque des revendications de 1 à 6.

9. Le support de stockage (955) lisible par ordinateur non transitoire d'après la revendication 8, sachant que le fait de déterminer la deuxième logique de compression de données comprend le fait de :

déterminer un ou plusieurs types de motifs de données associés aux données d'horodatage de nœuds de capteurs (104 ; 604 ; 704) sur la base d'une information d'horodatage triée et d'une fréquence de transmission de données provenant d'une pluralité de nœuds de capteurs (A-Z) ;
à partir du ou des types de motifs de données déterminés associés à des données d'horodatage de nœuds de capteurs (104 ; 604 ; 704), déterminer une heure de début, un compte d'un nombre d'intervalles (610 ; 710 ; 804), un ou plusieurs intervalles et un nombre de nœuds de capteurs (614 ; 714 ; 808, 816) ; et de
sur la base de l'heure de début, du compte d'un nombre d'intervalles (610 ; 710 ; 804), d'un ou plusieurs intervalles et du nombre de nœuds de capteur tous déterminés, compresser l'ensemble de données incluant les données d'horodatage de nœud de capteur (104 ; 604 ; 704).

| SENSOR ID | TIMESTAMP | MEASUREMENT |
|---|---|---|
| 1 | 20141017145610 | 10 |
| 2 | 20141017145610 | 10 |
| 1 | 20141017145611 | 10 |
| 2 | 20141017145611 | 11 |
| 2 | 20141017145612 | 10 |
| 1 | 20141017145612 | 11 |
| 1 | 20141017145613 | 10 |
| 2 | 20141017145613 | 11 |
| 1 | 20141017145614 | 10 |
| 2 | 20141017145614 | 11 |
| 1 | 20141017145615 | 10 |
| 2 | 20141017145615 | 10 |
| 1 | 20141017145616 | 10 |
| 2 | 20141017145616 | 10 |

**102**      **104**      **106**

TABLE 1

**FIG. 1**

EP 3 128 675 B1

FIG. 2

COLUMN STORE A

COLUMN STORE C

COLUMN STORE D

COLUMN STORE B

X =

FIG. 3

EP 3 128 675 B1

| SENSOR ID |
|:---:|
| 1 |
| 2 |
| 3 |
| 4 |
| 1 |
| 2 |
| 3 |
| 4 |
| 1 |
| 2 |
| 3 |
| 4 |
| 2 |
| 3 |
| 4 |
| 1 |
| 2 |
| 3 |
| 4 |

402
404
406
408
410

COLUMN STORE A

X =

| PATTERN |
|:---:|
| 1 |
| 2 |
| 3 |
| 4 |

COLUMN STORE B

| SENSOR ID |
|:---:|
| X |
| X |
| X |
| X(0) |
| X |

COLUMN STORE C

| BIT INDICATOR |
|:---:|
| 1 |
| 1 |
| 1 |
| 1 |
| 1 |

COLUMN STORE D

FIG. 4

FIG. 5

| SENSOR ID | TIMESTAMP | MEASUREMENT |
|-----------|-----------|-------------|
| 1 | 20141017145610 | 10 |
| 2 | 20141017145610 | 10 |
| 3 | 20141017145610 | 10 |
| 4 | 20141017145610 | 11 |
| 1 | 20141017145611 | 10 |
| 2 | 20141017145611 | 11 |
| 3 | 20141017145611 | 10 |
| 4 | 20141017145611 | 11 |
| 1 | 20141017145612 | 10 |
| 2 | 20141017145612 | 11 |
| 3 | 20141017145612 | 10 |
| 4 | 20141017145612 | 10 |

N1, N2, N3

602   604   606

TABLE 1

| START TIME | NUMBER OF INTERVALS | INTERVALS | NUMBER OF SENSOR NODES |
|------------|---------------------|-----------|------------------------|
| 20141017145610 | 3 | 1 | 4 |

608   610   612   614

TABLE 2

**FIG. 6**

22

| SENSOR ID | TIMESTAMP | MEASUREMENT |
|---|---|---|
| 1 | 20141017145610 | 10 |
| 2 | 20141017145610 | 10 |
| 3 | 20141017145610 | 10 |
| 4 | 20141017145610 | 11 |
| 1 | 20141017145611 | 10 |
| 2 | 20141017145611 | 11 |
| 3 | 20141017145611 | 10 |
| 4 | 20141017145611 | 11 |
| 1 | 20141017145612 | 10 |
| 2 | 20141017145612 | 11 |
| 3 | 20141017145612 | 10 |
| 4 | 20141017145612 | 10 |
| 2 | 20141017145613 | 11 |
| 3 | 20141017145613 | 10 |
| 4 | 20141017145613 | 10 |

B1 { (rows 13–15)

702    704    706

TABLE 1

| START TIME | NUMBER OF INTERVALS | INTERVALS | NUMBER OF SENSOR NODES |
|---|---|---|---|
| 20141017145610 | 3 | 1 | 4 |
| 20141017145613 | 1 | 1 | 1 |

708    710    712    714

TABLE 2

## FIG. 7

23

| START TIME | NUMBER OF INTERVALS | INTERVALS | NUMBER OF SENSOR NODES |
|---|---|---|---|
| 20141017145610 | 3 | 1 | 4 |
| 20141017145613 | 10 | 1 | 3 |
| 20141017145623 | 20 | 1 | 4 |
| 20141017145642 | 17 | 1 | 3 |
| 20141017145659 | 23 | 1 | 4 |
| 20141017145681 | 5 | 10 | 3 |
| 20141017145731 | 15 | 10 | 4 |

802  804  806  808

TABLE 1

| START TIME | START ROW POSITION | INTERVALS | NUMBER OF SENSOR NODES |
|---|---|---|---|
| 20141017145610 | 0 | 1 | 4 |
| 20141017145613 | 12 | 1 | 3 |
| 20141017145623 | 42 | 1 | 4 |
| 20141017145642 | 122 | 1 | 3 |
| 20141017145659 | 173 | 1 | 4 |
| 20141017145681 | 265 | 10 | 3 |
| 20141017145731 | 280 | 10 | 4 |

810  812  814  816

TABLE 2

FIG. 8

FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014122022 A1

**Non-patent literature cited in the description**

- **DIOP A. ; QI Y. ; WANG Q.** *An Efficient and Secure Session Key Management Scheme for Cluster Based Wireless Sensors Networks,* 2014

- Pervasive Computing and the Networked World. ICPCA/SWS 2013. Lecture Notes in Computer Science. Springer, vol. 8351
- **D. SALOMON et al.** Data Compression 4th edition. Springer Verlag, 2007, 47-169